# EUROPEAN PATENT APPLICATION

(11) **EP 4 607 959 A1**
(43) Date of publication of application: **27.08.2025**
(21) Application number: 24159786.3
(22) Date of filing: 26.02.2024
(51) Int. Cl.: H04R 19/00, B81B 3/00

(54) **SEMICONDUCTOR DEVICES, MICROELECTROMECHANICAL SYSTEM AND METHODS**

(71) Applicant: Infineon Technologies AG, 85579 Neubiberg (DE)
(72) Inventor: TIMME, Hans-Jörg, 85521 Ottobrunn (DE); FREY, Alexander, 93138 Lappersdorf (DE); OOI, Jun Cheng, 11700 Gelugor (MY); SCHUSTER, Markus, 81371 München (DE); ONARAN, Abidin Güclü, 81927 München (DE); BASAVANNA, Abhiraj, 81739 München (DE); TKACHUK, Konstantin, 82008 Unterhaching (DE); FÜLDNER, Marc, 85579 Neubiberg (DE)
(74) Representative: 2SPL Patentanwälte PartG mbB

(57) **Abstract**

Examples provide a semiconductor device. The semiconductor device comprises a flexible element configured to convert a sound wave into a displacement of the flexible element. The semiconductor device further comprises a layer spaced apart from and facing the flexible element and an anti-sticking element arranged between the flexible element and the layer. The anti-sticking element is arranged on the flexible element or the layer. The anti-sticking element is configured to maintain a minimum distance between the flexible element and the layer. An average surface roughness of a surface of the anti-sticking element facing the other one of the flexible element or the layer is at least 2 nm.

## Description

### Field

Examples relate to semiconductor devices, a microelectromechanical system and methods.

### Background

Microelectromechanical structures (MEMS) using a deflectable membrane may be implemented for a plurality of use cases such as microphones, loudspeakers, pressure sensors or the like. To prevent sticking between the membrane structure and a further structure adjacent the membrane, anti-sticking elements may be arranged between the membrane structure and the further structure. However, there is a tradeoff between the functionality of an anti-sticking element and the structural integrity of the MEMS system. For example, a small anti-sticking element may provide good anti-sticking characteristics but may damage the membrane during use. A wider anti-sticking element may not damage the membrane at all but may come with the drawback of a reduced anti-sticking characteristic. Thus, there may be a demand for an improved anti-sticking element.

### Summary

This demand may be satisfied by the subject matter of the independent claims.

Some aspects of the present disclosure relate to a semiconductor device comprising a flexible element configured to convert a sound wave into a displacement of the flexible element. The semiconductor device further comprises a layer spaced apart from and facing the flexible element and an anti-sticking element arranged between the flexible element and the layer. The anti-sticking element is arranged on the flexible element or the layer. The anti-sticking element is configured to maintain a minimum distance between the flexible element and the layer. An average surface roughness of a surface of the anti-sticking element facing the other one of the flexible element or the layer is at least 2 nm.

Some aspects of the present disclosure relate to a semiconductor device comprising a flexible element configured to convert a sound wave into a displacement of the flexible element. The semiconductor device further comprises a layer spaced apart from and facing the flexible element and an anti-sticking element arranged between the flexible element and the layer. The anti-sticking element is arranged on the flexible element or the layer. The anti-sticking element is configured to maintain a minimum distance between the flexible element and the layer. A surface of the anti-sticking element facing the other one of the flexible element or the layer comprises a recess. The recess has a depth of at least 10 nm.

Some aspects of the present disclosure relate to a MEMS system comprising a semiconductor device as described above.

Some aspects of the present disclosure relate to a method comprising forming a sacrificial layer over a flexible element or a counterpart layer of a microelectromechanical system. Further, the method comprises forming a recess in the sacrificial layer, a bottom of the recess comprising an average surface roughness of at least 2 nm. Further, the method comprises filling the recess and covering the sacrificial layer and removing the sacrificial layer to form the other one of the flexible element or the counterpart layer.

Some aspects of the present disclosure relate to a method comprising forming a sacrificial layer over a flexible element or a counterpart layer of a microelectromechanical system. Further, the method comprises forming a recess in the sacrificial layer, the recess comprising a protruding portion in a center of the recess. The protruding portion has a height of at least 10 nm. The method further comprises filling the recess and covering the sacrificial layer and removing the sacrificial layer to form the other one of the flexible element or the counterpart.

### Brief description of the Figures

Some examples of apparatuses and/or methods will be described in the following by way of example only, and with reference to the accompanying figures, in which
Figs. 1a and 1b show schematic views of cross sections of semiconductor devices;
Figs. 2a-2e show schematic views of cross sections and top views of anti-sticking elements;
Figs. 3a-3c show schematically a manufacturing process of a semiconductor device;
Figs. 4a-4c show schematically a manufacturing process of another semiconductor device;
Figs. 5a and 5b show images of cross-sections of exemplary anti-sticking elements;
Fig. 6 shows images of cross-sections of further exemplary anti-sticking elements;
Fig. 7 shows an image of a top view of a further exemplary anti-sticking elements;
Fig. 8 shows a block diagram of a method for manufacturing a semiconductor device;
Fig. 9 shows a block diagram of another method for manufacturing a semiconductor device;
and
Fig. 10 shows a schematic view of a cross section of a MEMS system.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e., only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

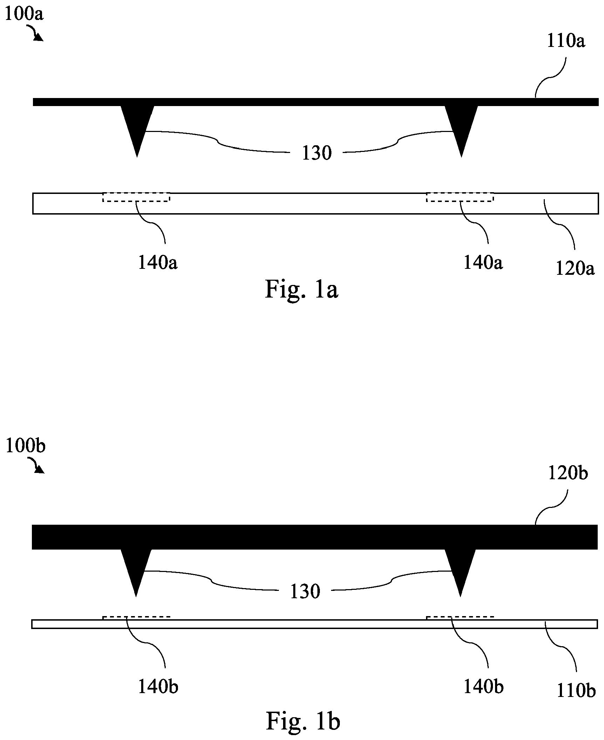

Figs. 1a and 1b show schematic views of cross sections of semiconductor devices 100a, 100b. As can be seen in Figs. 1a and 1b the semiconductor devices 100a, 100b comprise a flexible element 110a, 110b configured to convert a soundwave into a displacement of the flexible element 110a, 110b.

For example, the flexible element 110a, 100b may be a membrane as used for microphones, a diaphragm as used for loudspeakers or a membrane as used for pressure sensors. The flexible element 110a, 110b may be part of an electrode structure or may be an electrode structure. That is, the flexible element 1 10a, 110b may form at least part of a deflectable electrode. The flexible element 110a, 100b may comprise or may be made of a semiconducting material such as silicon, silicon carbide, silicon germanium, silicon nitride for example.

The semiconductor devices 100a, 100b further comprise a layer 120a, 120b spaced apart from and facing the flexible element 110a, 110b. The flexible element 110a, 110b, is deflectable with respect to the layer 120a, 120b of the semiconductor device 100a, 100b. That is, the layer 120a, 120b may form a further electrode structure. Thus, the flexible element 110a, 110b and the layer 120a, 120b may form a capacitive sensing arrangement. That is, a deflection of the flexible element 110a, 110b may be detected, sensed or measured due to a varying distance between the flexible element 110a, 110b and the layer 120a, 120b. For example, the varying distance may be detected, sensed or measured by a varying capacitance between the flexible element 110a, 110b and the layer 120a, 120b. Optionally, also the layer 120a, 120b may be deflectable with respect to the flexible element 110a, 110b. That is, the layer 120a, 120b may be a less flexible part with respect to the flexible element 110a, 110b. For example, the layer 120a, 120b may be almost rigid. However, a varying distance between the flexible element 110a, 110b and the layer 120a, 120b can be caused by a movement of the flexible element 110a, 110b and optionally a (less intense) movement of the layer 120a, 120b.

The layer 120a, 120b may be a backplate or a stator, for example. The layer 120a, 120b may comprise or may be made of a semiconducting material such as silicon, silicon carbide, silicon germanium, silicon nitride, for example.

The flexible element 110a, 100b and the layer 120a, 120b may form a stack. The layer 120a, 120b and the flexible element 110a, 100b may be held, fixed and/or clamped at respective outer regions, e.g., with a substrate structure or by a post (e.g., a remaining portion of a sacrificial layer) between both. For example, the substrate structure may comprise, for example, amorphous, polycrystalline or monocrystalline semiconductor materials such as silicon, silicon carbide, silicon germanium, silicon oxide or silicon nitride.

The semiconductor devices 100a, 100b further comprise an anti-sticking element 130 arranged between the flexible element 110a, 110b and the layer 120a, 120b. The anti-sticking element 130 is arranged on the flexible element 110a (Fig. 1a) or the layer 120b (Fig. 1b). Therefore, the semiconductor device 100a differs from the semiconductor device 100b in that the anti-sticking element 130 is arranged on the flexible element 110a and not on the layer 120b.

The anti-sticking element 130 is configured to maintain a minimum distance between the flexible element 110a, 110b and the layer 120a, 120b. That is, the anti-sticking element 130 may prevent a contact between the flexible element 110a, 110b and the layer 120a, 120b. For example, the anti-sticking element 130 may protrude from the flexible element 110a and/or the layer 120b. For example, the anti-sticking element 130 may comprise a protruding portion. Thus, when the flexible element 110a, 110b comes to close to the layer 120a, 120b, the anti-sticking element 130 touches the flexible element 110b or the layer 120a and prevents the flexible element 110a, 110b from coming into contact with the respective layer 120a, 120b.

A protruding part of the anti-sticking element 130, e.g., a protruding portion, may have a height of at least 600nm, or at least 700 nm, or at least 800 nm, or at least 1000 nm, or at least 1200 nm and/or at most of 2000 nm, or at most 1700 nm, or at most 1400 nm. For example, the length of the anti-sticking elements 130 may be around half a gap height between membrane 110a, 110b and layer 120a, 120b. The anti-sticking element 130 may have an outer dimension (such like a width or a length) of a base of at least 1,5 µm, or at least 2 µm, or at least 2.5 µm, or at least 3 µm and/or at most 10 µm, or at most 7 µm, or at most 5 µm or at most 3 µm.

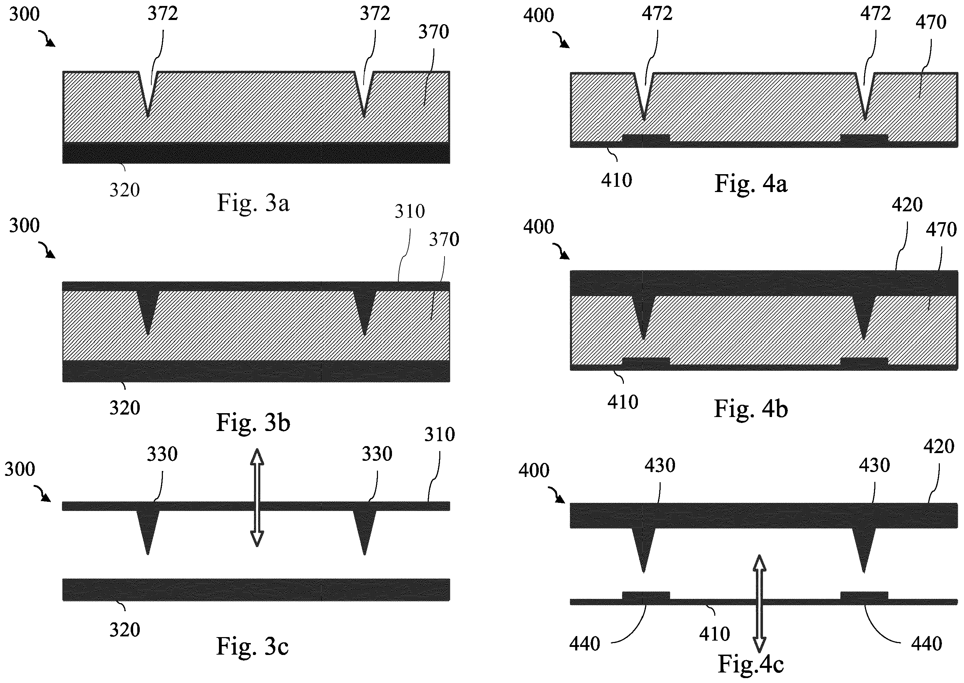

A way for manufacturing an anti-sticking element 130 is to form the anti-sticking element 130 by using recesses in a sacrificial layer, filling the recesses, followed by arranging an electrode structure on top of the sacrificial material (as described with reference to Fig. 3 and Fig. 4). Whilst this does not exclude to form at least a subset of the anti-stiction bumps as stalagmite structures, forming the anti-sticking element 130 as stalactite structures allows for simple processes. That is, the anti-sticking element 130 may be arranged at a mobile, i.e., a deflectable part, the flexible element 110a, and/or an immobile or almost rigid part, the layer 120b.

The anti-sticking element 130 may be made or may comprise silicon nitride, polycrystalline silicon, silicon dioxide,, a fluoropolymer coating (e.g., Teflon) and/or a metal (e.g., gold, nickel). The anti-sticking element may be formed in the same process step with the flexible element 110a or the layer 120b. In this case, a material of the anti-sticking element 130 may be identical to the flexible element 110a or the layer 120b. Alternatively, the anti-sticking element 130 may comprise a material different form the flexible element 110a or the layer 120b. That is, the anti-sticking element 130 may be formed in a different process step than the process step for forming the flexible element 110a or the layer 120b. In this case, the anti-sticking element 130 may be attached to the flexible element 110a or the layer 120b.

An anti-stiction bump may be a small protrusion placed on surfaces to mitigate stiction effects. Often multiple anti-stiction bumps are strategically placed in patterns. These anti-stiction bumps work by altering the contact area between surfaces, reducing the likelihood of strong adhesion forces. Anti-stiction bumps can distribute contact forces over a larger area, preventing damage at a specific point. Further, the material, geometry and placement of anti-stiction bumps can reduce adhesion forces between the surfaces, making it more difficult for them to stick together.

However, an effectiveness of an anti-stiction bump depends on the contact area of the anti-stiction bump. In general, a smaller contact area, i.e., a smaller anti-stiction bump, leads to smaller adhesion forces and an increased anti-sticking effect. Thus, a sharp anti-stiction bump can be used to reduce the adhesion forces. However, the contact forces of a sharp anti-stiction bump are concentrated on a very small area, and the sharp tip of the sharp anti-stiction bump may penetrate and even damage a structure of a semiconductor device, e.g., a membrane. That is, sharp anti-stiction bumps are fragile and may get damaged or may damage other structures in use, leading to debris and malfunction of semiconductor devices or MEMS systems.

A wide anti-stiction bump may provide an improved robustness of the anti-stiction bump and also smaller contact forces per area. Thus, a damage of the semiconductor due to the wide anti-stiction bump is less likely. However, the wide anti-stiction bump comes with a large contact area (proportional to diameter squared) and therefore large adhesion forces. Thus, the effectiveness of a wide anti-stiction bump is reduced and prone to sticking.

Thus, there is a tradeoff between robustness and effectiveness of an anti-stiction bump. It is a finding of the inventors, that an anti-sticking element 130 can be provided, which combines the advantages of both, a sharp anti-stiction bump and a wide anti-stiction bump and at the same time overcomes their disadvantages. The anti-sticking element 130 may comprise a large diameter forming an outer contact zone, and such increases a mechanical stability of the anti-sticking element 130. Further, the anti-sticking element 130 may reduce a contact area in the middle of the anti-sticking element 130 by a structured surface of the anti-sticking element 130. In this way, the robustness of the anti-sticking element 130 can be increased while preserving an effectiveness of an anti-sticking effect. The anti-sticking element 130 may be an anti-stiction bump with a specific design, for example, with a concave surface and/or a rough surface.

The contact zone may be the outer dimension of the surface of the anti-sticking element 130 that may come into contact with the other one of the flexible element 110b or the layer 120a. That is, the contact zone may define a mechanical stability of the anti-sticking element 130 and optionally a likelihood for damaging the flexible element 110b. The deflection of the flexible element 110b is governed by line forces along the perimeter of the contact zone, i.e., it is the outer dimension of the anti-sticking element 130 contacting the flexible element 110b that is important. The larger the outer dimension of the contact zone, the less likely a damage of the semiconductor device 100a, 100b. Therefore, the anti-sticking element 130 may comprise a large contact zone dimension/diameter (comparable to a wide anti-stiction bump).

The contact area can be the surface that the other one of the flexible element 110b or the layer 120a can actually touch to prevent sticking. That is, the contact area may be the part of the anti-sticking 130 element that actually prevents sticking between the flexible element 110b and the layer 120b or between the flexible element 110a and the layer 120a, respectively.

With an anti-stiction bump, the contact zone scales with the contact area, e.g., the contact zone equals the contact area. As a consequence, a large contact zone means a large contact area. That is, the adhesion forces are proportional to the contact area and thus to the contact zone for an anti-stiction bump. Therefore, a large contact zone, which is necessarily to reduce or prevent damages, leads to a decreased effectiveness of the anti-sticking effect, i.e., may decrease or even prevent an un-sticking. It is a finding of the inventors, that a size of the contact zone can be decoupled from a size of the contact area by adjusting the shape (e.g., providing a ring shape anti-sticking element 130) and/or a surface (e.g., providing a desired increased surface roughness) of the anti-sticking element 130. That is, a size of the contact area may be decoupled from a size of the contact zone by the anti-sticking element 130. In this way, the anti-sticking element 130 can be designed such that an effectiveness of un-sticking and a stability of the anti-sticking element 130 can be adjusted independently of each other. For example, the anti-sticking element 130 may feature a contact zone that is larger than the contact area.

In addition to preventing sticking between the flexible element 110a, 110b and the layer 120a, 120b, an anti-sticking element 130 must also allow itself to un-stick after a contact situation. Un-sticking of the anti-sticking element 130 requires that restoring forces are stronger than adhesion forces acting on the contact area. The adhesion forces are proportional to the contact area. Therefore, a large contact area leads to a decreased effectiveness of un-sticking, and may even prevent an un-sticking. While a large enough contact zone of an anti-sticking element 130 is mandatory for anti-sticking in case of a forced contact, the contact area must be small enough for un-sticking of elements 130 after a forced contact situation. By decoupling the size of the contact area from the contact zone, the anti-sticking element 130 can be adjusted so that both effects can be taken into account. That is, the anti-sticking element 130 can be adjusted to account for a small contact area and a large contact zone. That is, the anti-sticking element 130 may be designed and processed in such a way that the contact area may be significantly smaller than the contact zone, for example. For example, the ratio contact area divided by contact zone area may be smaller than 75%, or smaller than 60%, or smaller than 50%, or smaller than 35%, or smaller than 25%. For example, the contact area may be reduced by a ring-shaped anti-sticking element 130, or by a concave surface of the anti-sticking element 130. Optionally or additionally, the (reduced) contact area may be (further) reduced by an increased average surface roughness of the anti-sticking element 130 and/or the facing contact partner. The facing contact partner may be a contact zone 140a or a contact pad 140b, as described below. For example, a surface roughness of the contact partner can be increased in order to reduce a contact area on the side of the contact partner.

In an example, the average surface roughness of a surface of the anti-sticking element 130 facing the other one of the flexible element 110b or the layer 120a may be at least 2 nm, or at least 3 nm, or at least 4 nm, or at least 7 nm, or at least 10 nm, or at least 15 nm. Surface roughness refers to irregularities or variations in the surface texture of an object. It is a measure of the finely spaced and irregular microscopic and macroscopic features on the surface of a material. These features can include peaks, valleys, grooves, and other deviations from an ideal surface.

For example, the surface roughness can be quantified using parameters that describe the height, spacing, and distribution of surface irregularities. The measurement is typically expressed in terms of Ra (average roughness) or Rz (average maximum height). Ra is the arithmetic average of the absolute values of the roughness profile ordinates. For example, the average surface roughness may be the average roughness Ra. Alternatively, the average surface roughness may be the average maximum height Rz. Rz represents the average of the five highest peaks and the five deepest valleys in the surface profile.

By manufacturing an intentionally roughened surface, a contact area of the anti-sticking element 130 can be decreased while preserving a large outer dimension, and thus a large contact zone, of the anti-sticking element 130. That is, the area of the contact area can be reduced by an increased surface roughness. The contact area formed by an increased surface roughness is also referred to as effective contact area. That is, the anti-sticking element 130 may comprise an increased outer dimension, and thus an increased contact zone, which faces the other one of the flexible element 110b or the layer 120a, and which increases a mechanical stability of the anti-sticking element 130 (comparable to a wide anti-stiction bump). Further, the anti-sticking element 130 may comprise a decreased effective contact area due to the average surface roughness which improves the anti-sticking effect (comparable to a sharp anti-stiction bump). In this way, the anti-sticking element 130 can combine the advantages of a sharp anti-stiction bump and a wide anti-stiction bump and at the same time overcome their disadvantages.

According to this invention, the anti-sticking element 130 may provide a large outer dimension and thus a large contact zone combined with a small contact area in contrast to classical anti-stiction bumps. Therefore, the anti-sticking element 130 may provide an improved effectiveness of an anti-sticking effect with an improved mechanically stability in comparison to known anti-stiction bumps.

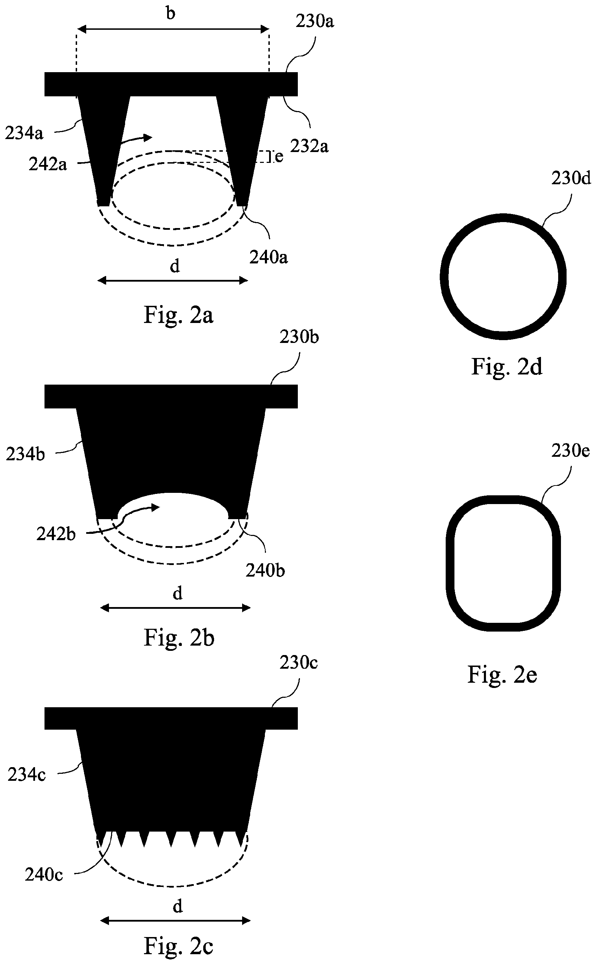

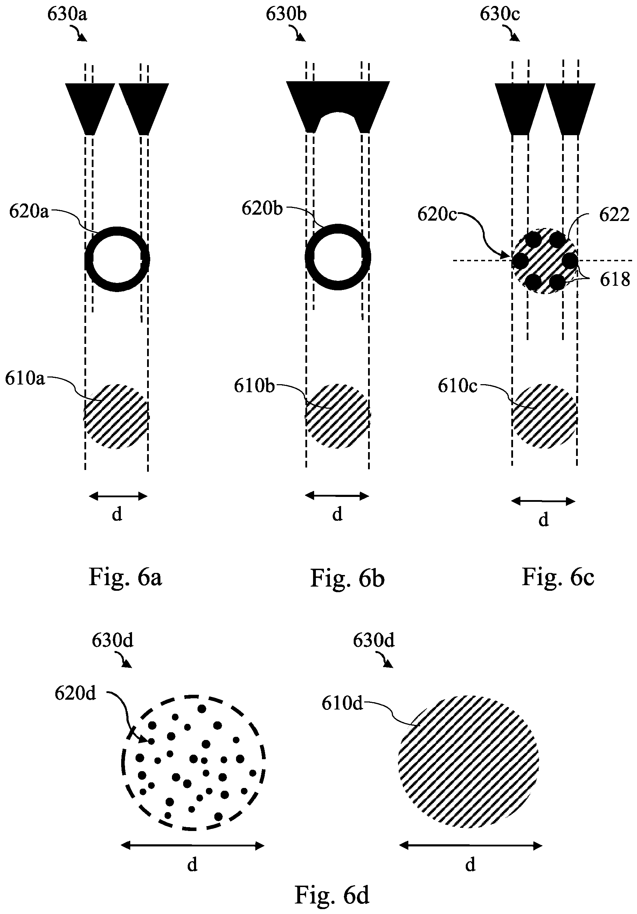

The anti-sticking element 130 can have contact areas of any desired shape, such like circular, rectangular, elliptical. The contact area can be simply connected like a ring, for example, or multiply connected by combining several smaller circular or ring areas (see Fig. 6), for example. Some examples of anti-sticking elements 130 according to this invention are discussed in more detail with reference to Fig. 2.

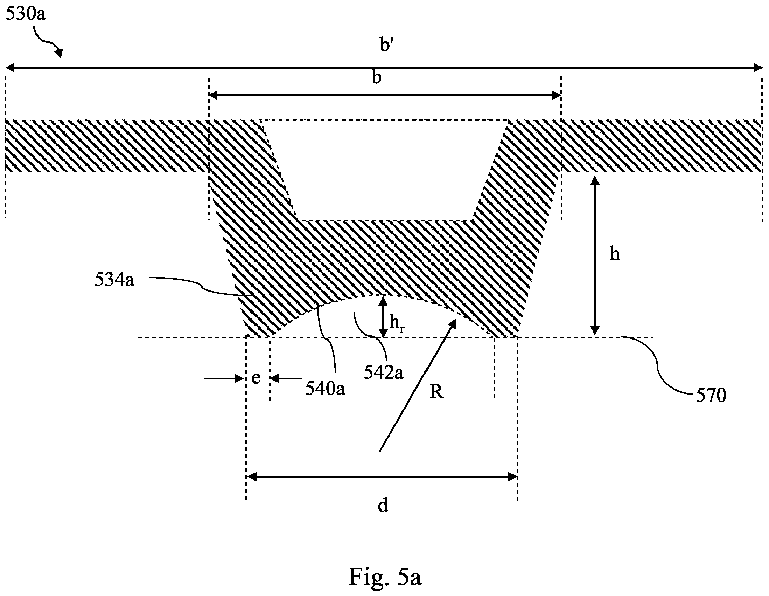

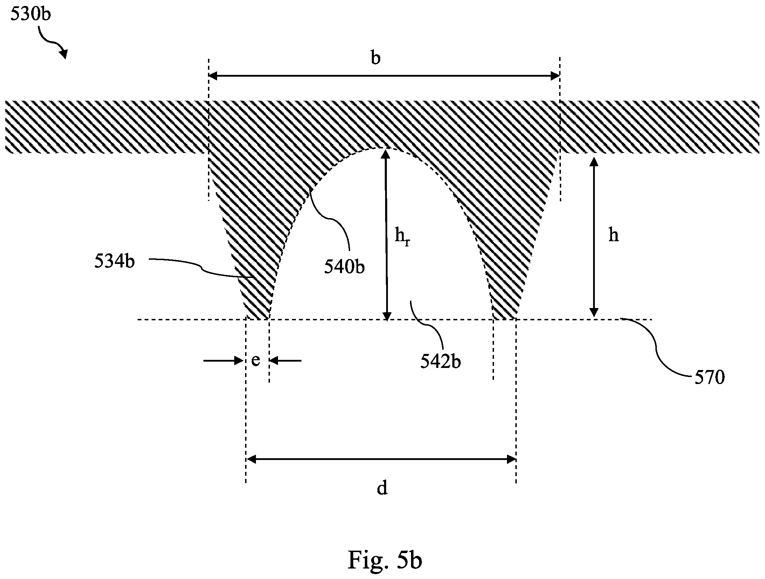

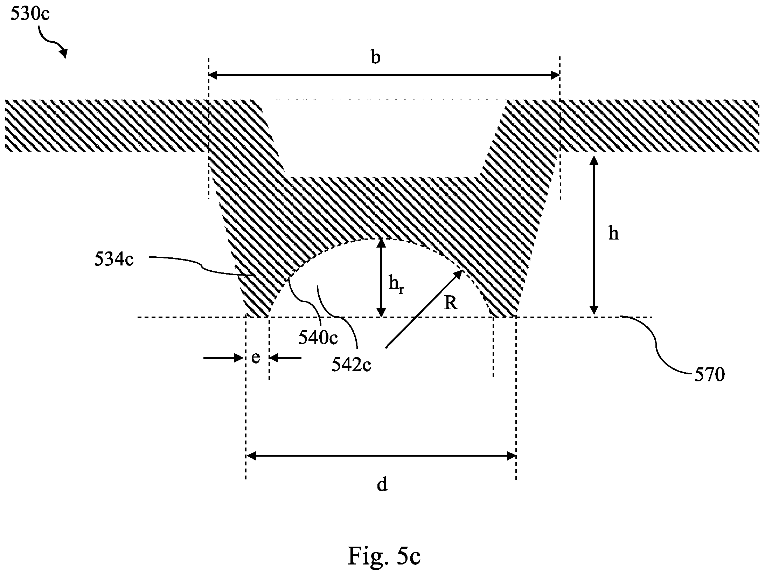

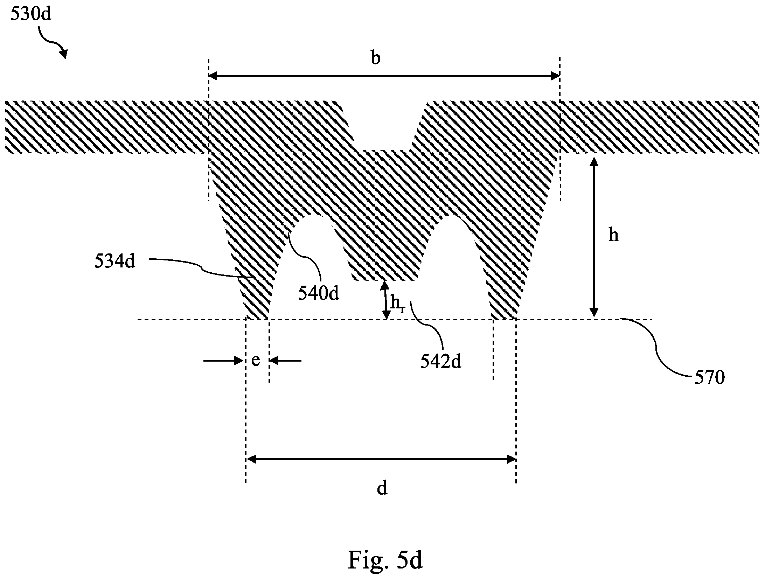

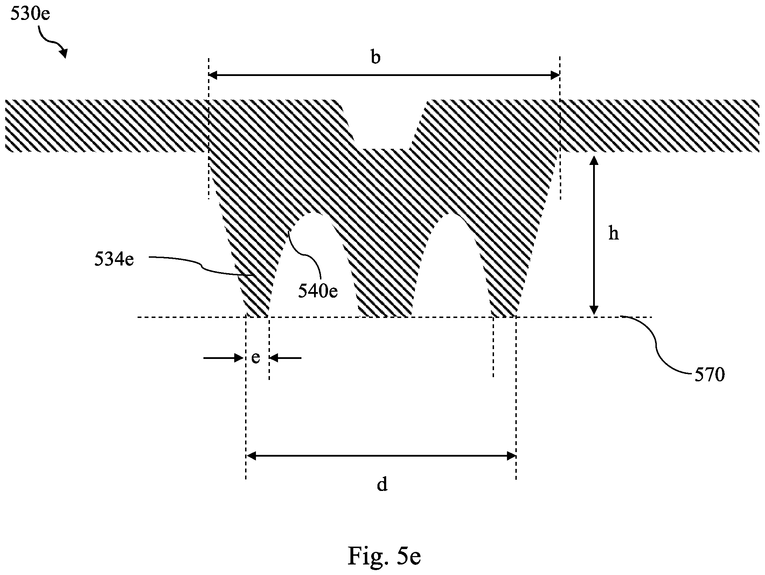

Alternatively or optionally to the average surface roughness, the surface of the anti-sticking element 130 facing the other one of the flexible element 110b or the layer 120a may comprise a recess, wherein the recess has a depth of at least 10 nm. The recess leads to a reduced contact area. A height of the protruding portion in a center of the recess may be at most as large as a height of the recess at the perimeter to ensure that the contact zone is defined by an outer perimeter of the anti-sticking element 130 (see also Fig. 5). For example, the recess may have a depth of at least 10 nm, or at least 20 nm, or at least 30 nm, or at least 40 nm and/or at most 100 nm, or at most 80 nm, or at most 60 nm, or at most 50 nm.

That is, the specific design of the anti-sticking element 130 allowing to decouple a size of the contact zone from a size of the contact area may be provided by an average surface roughness (leading to an effective contact area), a recess (leading to a reduced contact area) or a combination thereof (leading to a reduced effective contact area). That is, the surface of the anti-sticking element 130 may comprise a recess of at least 10 nm and/or an average surface roughness of at least 2 nm.

In an example, a surface of the anti-sticking element facing the other one of the flexible element or the layer comprises a recess, wherein the recess has a depth of at least 10 nm, or at least 3 nm, or at least 4 nm, or at least 7 nm, or at least 10 nm, or at least 15 nm. Forming a recess may allow to reduce the contact area in a center part of the anti-sticking element 130. In this way, the contact area of the anti-sticking element 130 can be reduced without affecting the contact zone of the anti-sticking element 130. That is, forming the recess allows to improve the un-sticking behavior of the anti-sticking element 130 without sacrificing its robustness and anti-sticking performance.

Using a recess to reduce the contact area may allow an improved adjustment of the contact area in comparison to an average surface roughness. For example, the recess may be arranged at a center position of the anti-sticking element 130. Thus, a center area of the anti-sticking element 130 may not touch the other one of the flexible element 110b or the layer 120a. The recess may preferably have a depth to ensure that only a perimeter of the anti-sticking element 130 may touch the other one of the flexible element 110b or the layer 120a.

For example, the recess may allow to form a ring-shaped anti-sticking element 130. The width of the ring-shaped anti-sticking element 130 can be adjusted by the parameter of the recess, e.g., a width and a depth of the recess. For example, a wider recess and/or a deeper recess may reduce the width of the ring-shaped anti-sticking element 130. That is, an intended design of the anti-sticking element 130 can be adjusted by design and process parameters of the recess.

For example, a depth of the recess may be larger as an average surface roughness to ensure a desired manufacturing of the anti-sticking element 130 without side-effects of the average surface roughness. For example, when anti-sticking element 130 combines an average surface roughness with a recess, the depth of the recess may be larger than the average surface roughness.

In an example, the anti-sticking element 130 may have an at least partially circumferential protruding portion. In an example, the anti-sticking element 130 has a fully circumferential protruding portion. The circumferential protruding portion may be configured to touch the other one of the flexible element 110b or the layer 120a. Thus, the circumferential protruding portion may define the dimension of the contact zone and may also define the contact area of the anti-sticking element 130. The circumferential protruding portion may at least partially surround the recess.

For example, a radius of the circumferential protruding portion may define the outer dimension of the contact zone. For example, the contact area may depend on a width of the circumferential protruding portion. That is, the contact area can be reduced in comparison to the contact zone by the circumferential protruding portion. Optionally, a surface of the circumferential protruding portion facing the other one of the flexible element 110b or the layer 120a may have an average surface roughness as described above.

For example, the at least partially circumferential protruding portion may define the recess of the surface of the anti-sticking element 130. That is, the protruding portion may at least partially surround an inner area, e.g., a center part of the anti-sticking element 130. The protruding portion may prevent that the surrounded inner area can contact the other one of the flexible element 110b or the layer 120a. Thus, the inner area at least partly surrounded by the protruding portion may be the recess of the surface of the anti-sticking element 130. In an example, the at least partially circumferential protruding portion may be ring-shaped or rectangular. That is, the protruding portion may fully surround an inner area, which is not configured to touch the other one of the flexible element 110b or the layer 120a. Therefore, the inner area, e.g., the recess, may not contribute to adhesion forces.

In an example, a footprint of the at least partially protruding portion (e.g., a diameter of the protruding portion) may be at most 75%, or at most 70%, or at most 65%, or at most 60%, or at most 50% of a footprint of a base area of the anti-sticking element 130. The base area is the area of the element 130 where it is arranged on the flexible element 110a or the layer 120b. The footprint of the at least partially protruding portion, preferably of at most 75%, may decrease a contact area of the anti-sticking element 130. For example, the at least partially protruding portion may be a fully circular protruding portion with an outer radius R (defining an outer edge of the protruding portion) and an inner radius R/2 (defining an inner edge of the protruding portion).

In an example, the surface (facing the other one of the flexible element 110b or the layer 120a) along the recess of the anti-sticking element 130 may be concave. For example, the at least partially protruding portion may form the concave surface of the anti-sticking element 130. The concave surface may reduce a contact area while preserving large contact zone. That is, the dimension of the contact zone can be decoupled from the dimension of the contact area using a concave surface. In this way, a design of the anti-sticking element 130 can be improved. For example, the contact area can be considered to have a small width and may be flat. For the (inner) recess, however, a concave curvature may be required in order to avoid a contact and thus any contribution to adhesion forces of the anti-sticking element 130.

In an example, the at least partially circumferential protruding portion has a width of at most 300 nm, or at most 250 nm, or at most 200 nm, or at most 150 nm, or at most 100 nm. Optionally, when the protruding portion has an average surface roughness of at least 2 nm, a width of the circumferential protruding portion can be increased.

In an example, the at least partially circumferential protruding portion has an outer dimension (e.g. a diameter) of at least 500 nm, or at least 600 nm, or at least 700 nm, or at least 800 nm, or at least 1 µm. For example, the outer dimension may be defined by a diameter if the circumferential protruding portion has a circular shape. An outer perimeter length may be at least 1.5 µm , or at least 2 µm , or at least 3 µm. Thus, the anti-sticking element 130 may comprise a contact zone large enough to reduce the likelihood of damage of the semiconductor device 100a, 100b. If an outer shape of the contact area is not circular and/or if the contact area consist of several individual contact areas (also referred to as multiply connected contact area, see also Fig. 6c), the contact zone may be defined as the convex hull of the not circular or multiply connected contact area. The perimeter of the contact zone (e.g., a convex hull) is then precisely defined. In case of a circular contact area with diameter d, the contact zone is also a circular disc with diameter d.

In an example, a footprint of an area of the surface of the anti-sticking element 130 configured to contact the other one of the flexible element 110b or the layer 120a (i.e. the contact area of the anti-sticking element 130) is at most 75% %, or at most 70%, or at most 65%, or at most 60%, or at most 50% of a footprint of a base area of the anti-sticking element 130. In this way, the contact area of the anti-sticking element 130 can be decreased to increase effectiveness of an anti-sticking effect.

In an example, the anti-sticking element 130 may comprise or may be made of a material different from the flexible element 110a. In an example, the anti-sticking element 130 may comprise or may be made of at least one of a conductive material or an insulating material. In an example, the flexible element 110a, 110b and the layer 120a, 120b form a capacitor. That is, the flexible element 110a, 110b may form a first electrode and the layer 120a, 120b may form a second electrode of a capacitor.

As shown in Fig. 1b, when the anti-sticking element 130 is arranged on the layer 120b, the flexible element 110b may further comprise a contact pad 140b. The contact pad 140b may be disposed on the flexible element 110b. The contact pad 140b may be associated with a corresponding anti-sticking element 130b. The contact pad 140b may comprise a protrusion extending from the flexible element 110b in a direction towards the anti-sticking element 130. The contact pad 140b may comprise a different material than the flexible element 110b. The contact pad 140b may comprise a material that is more immune to cracking than the flexible element 1 10b, and in particular, has a higher fracture toughness than the flexible element 110b (e.g. silicon nitride). Alternatively, materials with similar or even lower fracture toughness (e.g., polysilicon) may be used for the contact pad 140b since the thickness increase provided by the contact pad 140b may help to dissipate the stress energy within the contact pad 140b and thereby avoiding it from reaching the flexible element 110b.

In principle, the contact pad 140b may help to reduce deformation of the underlying flexible element 130. For example, excessive stress applied by the anti-sticking element 130, which otherwise may have caused cracking of the flexible element 110b, may be absorbed by the contact pad 140b reducing or omitting damage to the flexible element 110b. For example, the contact pad 140b may comprise or may be made of silicon nitride layer, polysilicon layer, silicon oxide layer and/or silicon carbide layer. The contact pad 140b may range in size from 10 nm to 1 µm in thickness and may have a lateral dimension around 300 nm to 5 µm larger than that of the contact area of the anti-sticking element 130.

As show in Fig. 1a, when the anti-sticking element 130 is arranged on the flexible element 110a, the layer 120a may further comprise a contact zone 140a. In contrast to Fig. 1b, the contact zone 140a may be part of the layer 120a. That is, the contact zone 140a may be formed inside of the layer 120a. Alternatively, the contact zone 140a could also be a contact pad comparable to the contact pad 140b in Fig. 1b. In this case, the contact zone 140a would be arranged on the layer 120a.

Optionally, the contact zone 140a and/or the contact pad 140b may have a rough surface, e.g., a surface roughness of the contact zone 140a and/or the contact pad 140b may be at least 2 nm. That is, a contact area of the contact zone 140a and/or the contact pad 140 can be decreased by a surface roughness of the contact zone 140a and/or the contact pad 140.

More details and aspects are mentioned in connection with the examples described below. The example shown in Fig. 1 may comprise one or more optional or additional features corresponding to one or more aspects mentioned in connection with the proposed concept or one or more examples described below (e.g., Fig. 2 - 10).

Figs. 2a-2e show schematic views of cross sections of anti-sticking elements 230a, 230b, 230c, and also top views 230d, 230e. Fig. 2a-2c show cross-sections of three different examples of an anti-sticking element 230a, 230b, 230c.

Fig. 2c shows an example of an anti-sticking element 230c with an average surface roughness of at least 2 nm. As indicated by the multiple elevations the surface 240c of the protruding portion 234c has an average surface roughness of at least 2 nm. As described with reference to Fig. 1, the average surface roughness of the anti-sticking element 230c leads to a smaller effective contact area while preserving the dimension of the contact zone (indicated by the dotted line). That is, the effective contact area may be distributed over the entire surface 240c of the anti-sticking element 230c, and the contact zone may be defined by the outer dimension of the protruding portion 234c (see also Fig. 6d). For example, the anti-sticking element 230c may have a circular shape and thus the contact zone may have a circular shape with diameter d.

In contrast, Figs. 2a and 2b show anti-sticking elements 230a, 230b comprising a surface with a recess 242a, 242b. The periphery of the recess 242a, 242b is indicated by the inner dotted line. Thus, the (reduced) contact area of the anti-sticking element 230a and 230b may be defined by a surface 240a, 240b of the protruding portion 234a, 234b indicated by the two dotted lines. That is, the recess 242a, 242b may decrease the contact area of the anti-sticking element 230a, 230b while preserving a dimension of the contact zone. The recess 242a, 242b may especially decrease the contact area in a center area of the anti-sticking element 230a, 230. The contact zone can be independent of the recess 242a, 242b. The contact zone may be defined by the outer dotted line. For example, an outer dimension of the contact zone may be the distance d. The (reduced) contact area may be defined by the surface 240a, 240b of the protruding portion 234a, 234b. That is, the (reduced) contact area may be defined by the area between the dotted lines.

As can be seen in Figs. 2a and 2b, the shape of the recess is not limited to a special shape. For example, the recess 242a may extend to a base 232a of the anti-sticking element 230a, see Fig. 2a. That is, the protruding portion 234a, 234b may be ring-shaped. In this case, the anti-sticking element 230a may comprise a protruding portion 234a, 234b which could be shaped by a circular channel recess in a sacrificial layer, for example. Alternatively, as can be seen in Fig. 2b, the recess 242b may only be a shallow recess, for example, at least 10 nm depth. In this case, only the surface 240b may be ring-shaped, for example. The recess 242b can have any depth from the full height of the protruding portion 234a, 234b down to at least 10 nm.

The anti-sticking elements 230a, 230b, 230c may combine the advantages of a sharp anti-stiction bump with a wide anti-stiction bump (and avoid their disadvantages) by means of a specific bump design, e.g. a recess 242a, 242b and/or an average surface roughness. The anti-sticking elements 230a, 230b, 230c may provide a large cross-section and thus a large contact zone (e.g., defined by the outer dimension d such like a diameter) but a small contact area due to the ring-shape (of at least the surface 240a, 240b) with a small width and/or a sufficiently large average surface roughness.

For example, as shown in Figs. 2a and 2b the specific bump design may be a ring-shaped anti-sticking element 230a, 230b (e.g., like a donut). In this case, the anti-sticking element 230a, 230b may offer a ring-shaped contact area with outer diameter d and width e, thus providing a large contact zone diameter d (like a wide anti-stiction bump) combined with a small contact area (proportional to a width e of the surface 240a, 240b of the anti-sticking element 230a, 230b, see also Fig. 5). For example, as shown in Fig. 2c, a small contact area can also be realized by providing many small protruding portions. In addition, increasing the average surface roughness to at least 2 nm may further reduce the contact area to form an effective contact area.

Figs. 2d and 2e show top views of different examples of an anti-sticking elements 230d, 230e. For example, the anti-sticking element 230d, 230e may have a circular shape (Fig. 2d) or a substantially rectangular shape 230e (Fig. 2e). Other shapes of the anti-sticking element such like elliptical are also possible.

As can be seen in Fig. 2a, a base of an anti-sticking element 230a may be defined from the largest part of the protruding portion 234a, i.e., at the beginning of the protruding portion 234a. For example, b may be a width of the base of the anti-sticking element 230a.

More details and aspects are mentioned in connection with the examples described above and/or below. The example shown in Fig. 2 may comprise one or more optional or additional features corresponding to one or more aspects mentioned in connection with the proposed concept or one or more examples described above (e.g., Fig. 1) and/or below (e.g., Fig. 3 - 10).

Figs. 3a-3c show schematically a manufacturing process of a semiconductor device 300. In Fig. 3a a sacrificial layer 370 formed above the layer 320 may be structured. For example, a recess 372 may be etched into the sacrificial layer 370. As can be seen in Fig. 3b, the recess 372 may be filled. Filling the recess 372 may optionally comprising forming a flexible element 310. The flexible element 310 may be formed in the same process step as the filling of the recess 372. In this case, the flexible element 310 may be made of the same material as the filling of the recess 372. Alternatively, the flexible element 310 may be formed in a separate process step different from the process step for filling the recess 372. In this case, the material of the flexible element 310 may be different from the material of the filling of the recess 372.

As can be seen in Fig. 3c, the sacrificial layer 370 may be at least partially removed between the flexible element 310 and the layer 320 (e.g., such that posts remain to support the flexible element 310). Thus, the flexible element 310 can be deflected relative to the layer 320 (indicated by the arrow). The material of the filled recess 372 may form an anti-sticking element 330 as described above, e.g., with reference to Fig. 1a and/or Fig. 2.

More details and aspects are mentioned in connection with the examples described above and/or below. The example shown in Fig. 3 may comprise one or more optional or additional features corresponding to one or more aspects mentioned in connection with the proposed concept or one or more examples described above (e.g., Fig. 1 - 2) and/or below (e.g., Fig. 4 - 10).

Figs. 4a-4c show schematically a manufacturing process of another semiconductor device 400. In Fig. 4a a sacrificial layer 470 formed above the flexible element 410 may be structured. For example, a recess 472 may be etched into the sacrificial layer 470. As can be seen in Fig. 4b, the recess 472 may be filled. Filling the recess 472 may optionally comprising forming a layer 420. The layer 420 may be formed in the same process step as the filling of the recess 472. In this case, the layer 420 may be made of the same material as the filling of the recess 472. Alternatively, the layer 420 may be formed in a separate process step different from the process step for filling the recess 472. In this case, the material of the layer 420 may be different from the material of the filling of the recess 472. As can be seen in Fig. 4c, the sacrificial layer 470 may be at least partially removed between the flexible element 410 and the layer 420. Thus, the flexible element 410 can be deflected relative to the layer 420 (indicated by the arrow). The material of the filled recess 472 may form an anti-sticking element 430 as described above, e.g., with reference to Fig. 1b and/or Fig. 2. As can be seen in Figs. 4a-4c the flexible element 410 may comprise an optional contact pad 440, as described above.

More details and aspects are mentioned in connection with the examples described above and/or below. The example shown in Fig. 4 may comprise one or more optional or additional features corresponding to one or more aspects mentioned in connection with the proposed concept or one or more examples described above (e.g., Fig. 1 - 3) and/or below (e.g., Fig. 5 - 10).

Figs. 5a and 5b show cross-sections of exemplary anti-sticking elements 530a-530e. The anti-sticking element 530a shown in Fig. 5a comprises a concave surface 540a comprising a shallow recess 542a. In this case, the anti-sticking element 530a may offer a (reduced) contact area at the contact plane 570 with outer diameter d and width e, thus providing a large contact zone diameter d (like a wide anti-stiction bump) combined with a small contact area (proportional to a width e of the surface of the anti-sticking element 530a). The shallow recess 542a may be defined by a curvature radius R in conjunction with the depth hᵣ of the recess 542a.

In contrast, the anti-sticking element 530b shown in Fig. 5b comprises a ring-shaped protruding portion 534b and thus a recess 542b with a depth hᵣ substantially identical to the height h of the protruding portion 534b. Again, the anti-sticking element 530b may offer a (reduced) contact area at the contact plane 570 with outer diameter d and width e, thus providing a large contact zone diameter d (like a wide anti-stiction bump) combined with a small contact area (proportional to a width e of the surface of the anti-sticking element 530b).

Fig. 5c shows another example of an anti-sticking element 530c. The anti-sticking element 530c comprises a concave surface 540c comprising a recess 542c. A curvature radius R of the recess 542c is increased compared to Fig. 5a. That is, the recess 542c is deeper (i.e., hᵣ is larger) than the recess shown in Fig. 5a The anti-sticking element 530a may offer a (reduced) contact area at the contact plane 570 with outer diameter d and width e, thus providing a large contact zone diameter d (like a wide anti-stiction bump) combined with a small contact area (proportional to a width e of the surface of the anti-sticking element 530c).

Fig. 5d shows another example of an anti-sticking element 530d. The anti-sticking element 530d comprises a concave surface 540d and a recess 542d in the center. In this case, the depth hᵣ of the recess 542d is decoupled from the curvature radius. That is, a recess formed by the curvature radius may be different from the recess 542d formed in the center of the anti-sticking element 530d. In this way, the curvature radius, which affects the width e of the (reduced) contact area, can be adjusted independently of the recess 542d and thus of the height h of the protruding portion. In this way, an adjustment of the width e of the protruding portion 534d and thus of the (reduced) contact area can be improved. Depending on the depth hᵣ of the recess 542d, the recess 542d may contribute to the contact area or not. When the recess 542d contributes to the contact area, a contact force on the protruding portion 534d defining the contact zone can be reduced.

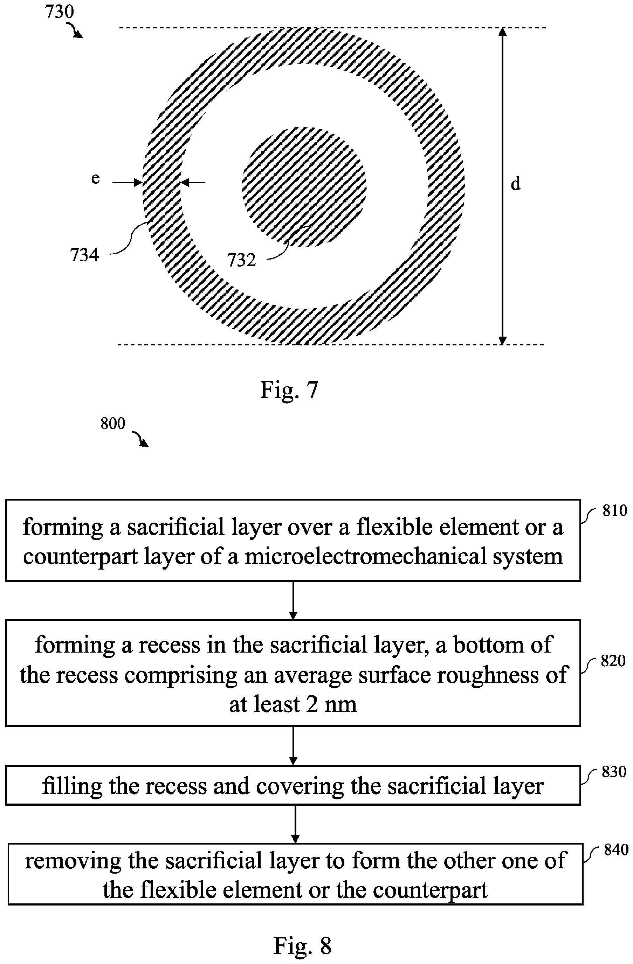

Fig. 5e shows another example of an anti-sticking element 530e. The anti-sticking element 530e comprises a concave surface 540e without a recess in the center. That is, a center portion (e.g., forming a second protruding portion) of the anti-sticking 530e can be located in the contact plane and thus may be part of the (reduced) contact area. In this way, the curvature radius can be adjusted independently. In this case, forming a further recess in the center of the anti-sticking element 530e can be omitted. Further, the contact force on a protruding portion 534e defining the contact zone can be reduced (see also Fig. 7).

For example, a base of an anti-sticking element 530a-530e may be defined from the largest part of the protruding portion, as described with reference to Fig. 2a. That is, a width of the base may correspond to the width b shown in Fig. 5a-5e. Alternatively, the base of an anti-sticking element 530a, 530b may be defined from the largest extension of the material of the anti-sticking element 530a, 530b. For example, the anti-sticking element 530a-530e may be made of a material different from that from the flexible element or the layer. In this case, the base of the anti-sticking element 530a, 530b may be defined by a width b' of the material, see Fig. 5a.

More details and aspects are mentioned in connection with the examples described above and/or below. The example shown in Fig. 5 may comprise one or more optional or additional features corresponding to one or more aspects mentioned in connection with the proposed concept or one or more examples described above (e.g., Fig. 1 - 4) and/or below (e.g., Fig. 6 - 10).

Fig. 6a-6c show schematic views of ring-shaped anti-sticking elements 630a, 630b, 630c and Fig. 6d shows a schematic view of an effective contact area of an anti-sticking element 630d with increased surface roughness. Figs. 6a and 6b disclose a simply connected (reduced) contact area 620a, 620b. That is, the (reduced) contact area 620a, 620b may be formed by only one ring-shaped element (e.g., only one protruding portion). For example, the anti-sticking element 630a, 630b may comprise only one element that defines the (reduced) contact area 620a, 620b and the contact zone 610a, 610b. For example, the anti-sticking element 630a, 630b may be formed by forming a recess in a center portion to reduce the (reduced) contact area 620a, 620b. Due to the ring-shape of the element the size of the contact zone 610a, 610b is decoupled from the size of the (reduced) contact area 620a, 620b. That is, the size of the (reduced) contact area 620a, 620b is much smaller than the size of the contact zone 610a, 610b. In this way, the anti-sticking element 630a, 630b may provide effective un-sticking by the (reduced) contact zone 610a, 610b while a large enough contact zone 610a, 610b for anti-sticking in case of a forced contact is preserved.

Fig. 6c shows a multiply connected (reduced) contact area 620c. That is, the (reduced) contact area 620a may be formed by at least two elements (118), e.g., six elements (for readability, only two elements are marked with a reference symbol) as shown in Fig. 6. The at least two elements 618 may define a convex hull 622. Even though the convex hull 622 is circular in Fig. 6c, the convex hull can have any desired shape depending on the arrangement of the at least two elements 618. The perimeter of the contact zone 610c (of the anti-sticking element 630c comprising a multiply connected (reduced) contact area 620c can then precisely be defined by the convex hull 622. In case of a circular (reduced) contact area 620c with diameter d as shown in Fig. 6c, the contact zone 610c is also a circular disc with diameter d.

Fig. 6d shows a schematic view of an effective contact area 610d of an anti-sticking element 630d with increased surface roughness. The effective contact area 610d is formed by increasing the surface roughness of the anti-sticking element 630d. In this way, the effective contact area 610d may be distributed over the entire surface of the anti-sticking element 630d still providing a reduction of the contact area in comparison to an anti-stiction bump with the same outer dimension. The contact zone 610d is not affected by the increased surface roughness. That is, the contact zone may be defined by the outer dimension, e.g., the diameter d, of a protruding portion. As shown in Fig. 6d, for example, the anti-sticking element 630d may have a circular shape and thus the contact zone 610d may have a circular shape with diameter d.

More details and aspects are mentioned in connection with the examples described above and/or below. The example shown in Fig. 6 may comprise one or more optional or additional features corresponding to one or more aspects mentioned in connection with the proposed concept or one or more examples described above (e.g., Fig. 1 - 5) and/or below (e.g., Fig. 7 - 10).

Fig. 7 shows a schematic top view of a further exemplary anti-sticking element 730. The anti-sticking element 730 comprises two protruding portions 732, 734, a first, inner protruding portion 732 and a second outer protruding portion 734. The second protruding portion 734 surrounds the first protruding portion 732 and thus defines the contact zone. That is, the contact zone has a diameter d. The first protruding portion 732 and the second protruding portion 734 define the (reduced) contact area. That is, the diameter of the first protruding portion 732 and the width e of the second protruding portion 734 may define the (reduced) contact area. Thus, a contact force can be distributed between the first protruding portion 732 and the second protruding portion 734. That is, a contact force acting on the second protruding portion 734 can be reduced by the first protruding portion 734. In this way, the contact force on a protruding portion defining the contact zone can be reduced.

More details and aspects are mentioned in connection with the examples described above and/or below. The example shown in Fig. 7 may comprise one or more optional or additional features corresponding to one or more aspects mentioned in connection with the proposed concept or one or more examples described above (e.g., Fig. 1 - 6) and/or below (e.g., Fig. 8 - 10).

Fig. 8 shows a block diagram of a method 800 for manufacturing a semiconductor device. The method 800 comprises forming 810 a sacrificial layer over a flexible element or a counterpart layer of a microelectromechanical system. Further, the method 800 comprises forming 820 a recess in the sacrificial layer, a bottom of the recess comprising an average surface roughness of at least 2 nm. Further, the method 800 comprises filling 830 the recess and covering the sacrificial layer and removing 840 the sacrificial layer to form the other one of the flexible element or the counterpart. A semiconductor device as described above, e.g., with reference to Fig. 1a can be formed according to method 800.

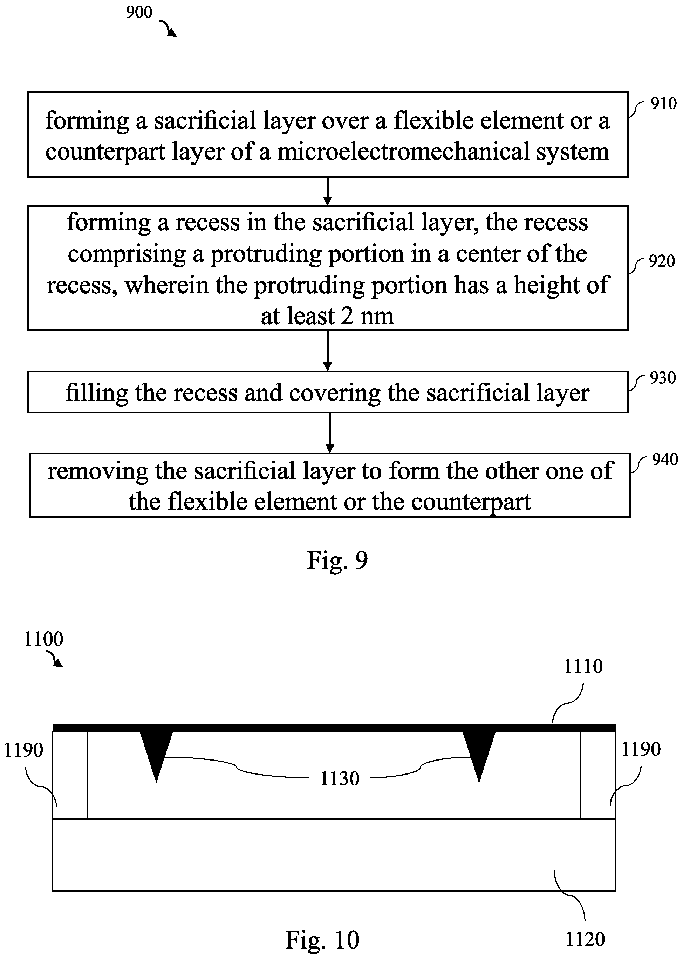

More details and aspects are mentioned in connection with the examples described above and/or below. The example shown in Fig. 8 may comprise one or more optional or additional features corresponding to one or more aspects mentioned in connection with the proposed concept or one or more examples described above (e.g., Fig. 1-7) and/or below (e.g., Fig. 9 - 10).

Fig. 9 shows a block diagram of another method 900 for manufacturing a semiconductor device. The method 900 comprises forming 910 a sacrificial layer over a flexible element or a counterpart layer of a microelectromechanical system. Further, the method 900 comprises forming 920 a recess in the sacrificial layer, the recess comprising a protruding portion in a center of the recess. The protruding portion has a height of at least 10 nm. The method 900 further comprises 930 filling the recess and covering the sacrificial layer and removing 940 the sacrificial layer to form the other one of the flexible element or the counterpart. A semiconductor device as described above, e.g., with reference to Fig. 1b can be formed according to method 900. As described above, the protruding portion (which later forms the recess of the anti-sticking element) may have preferably a larger height than 10 nm to ensure that the recess can be distinguished from an average surface roughness. The height of the recess can be chosen to any appropriate value to achieve a desired width of the protruding portion of the anti-sticking element.

More details and aspects are mentioned in connection with the examples described above and/or below. The example shown in Fig. 9 may comprise one or more optional or additional features corresponding to one or more aspects mentioned in connection with the proposed concept or one or more examples described above (e.g., Fig. 1 - 8) and/or below (e.g., Fig. 10).

Fig. 10 shows a schematic view of a cross section of a MEMS system 1100. The MEMS system 1100 comprises a semiconductor device as described above, e.g., with reference to at least on of Figs. 1-7. That is, the MEMS system 1100 comprises a flexible element 1110 configured to convert a sound wave into a displacement of the flexible element 1110. Further, the MEMS system 1100 comprises a second layer 1120 spaced apart from and facing the flexible element 1110 and an anti-sticking element 1130 arranged between the flexible element 1110 and the second layer 1120 and arranged on the flexible element 1110 or the second layer 1120.

The anti-sticking element 130 is configured to maintain a minimum distance between the flexible element 1110 and the second layer 1120.

An average surface roughness of a surface of the anti-sticking element 1130 facing the other one of the flexible element 1110 or the second layer 1120 may be at least 2 nm. Optionally or alternatively, a surface of the anti-sticking element 1130 facing the other one of the flexible element 1110 or the layer 1120 may comprise a recess. The recess has a depth of at least 10 nm

Further, the MEMS system 1100 may comprise a post structure 1190. For example, the post structure 1190 may be a remaining of a sacrificial layer used to form the anti-sticking element 1130 and the flexible element. Alternatively, the post structure may be a part of a substrate of the MEMS system 1100. The layer 1120 may be part of or may be the substrate or may be formed on the substrate.

The MEMS system 1100 in Fig. 10 is only one example. In other MEMS systems, the layer 1120 may be formed above the flexible element 1110 and supported by the supporting structure 1190 (e.g., see Fig. 1b).

In an example, the MEMS system 1100 may be a capacitor microphone. Alternatively, the MEMS system

More details and aspects are mentioned in connection with the examples described above and/or below. The example shown in Fig. 10 may comprise one or more optional or additional features corresponding to one or more aspects mentioned in connection with the proposed concept or one or more examples described above (e.g., Fig. 1 - 9).

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

In the following, some examples of the proposed concept are presented:
An example (e.g., example 1) relates to a semiconductor device, comprising a flexible element configured to convert a sound wave into a displacement of the flexible element, a second layer spaced apart from and facing the flexible element, and an anti-sticking element arranged between the flexible element and the second layer and attached arranged onto the flexible element or the second layer, the anti-sticking element configured to maintain a minimum distance between the flexible element and the second layer, and wherein an average surface roughness of a surface of the anti-sticking element facing the other one of the flexible element or the second layer is at least 2 nm.

An example (e.g., example 2) relates to a semiconductor device, comprising a flexible element configured to convert a sound wave into a displacement of the flexible element, a second layer spaced apart from and facing the flexible element, and an anti-sticking element arranged between the flexible element and the second layer and attached arranged onto the flexible element or the second layer, the anti-sticking element configured to prevent the flexible element and the second layer from sticking together, and wherein a surface of the anti-sticking element facing the other one of the flexible element or the second layer comprises a recess, wherein the recess has a depth of at least 10 nm.

Another example (e.g., example 3) relates to a previous example (e.g., one of the examples 1 or 2) or to any other example, further comprising that the anti-sticking element has an at least partially circumferential protruding portion.

Another example (e.g., example 4) relates to a previous example (e.g., example 3) or to any other example, further comprising that the at least partially circumferential protruding portion is ring-shaped or rectangular.

Another example (e.g., example 5) relates to a previous example (e.g., one of the examples 3 or 4) or to any other example, further comprising that a footprint of the at least partially protruding portion is at most 75% of a footprint of a base area of the anti-sticking element.

Another example (e.g., example 6) relates to a previous example (e.g., one of the examples 2 to 5) or to any other example, further comprising that the surface along the recess (242b) of the anti-sticking element is concave.

Another example (e.g., example 7) relates to a previous example (e.g., one of the examples 3-6) or to any other example, further comprising the at least partially circumferential protruding portion has a width of at most 300 nm.

Another example (e.g., example 8) relates to a previous example (e.g., one of the examples 3-7) or to any other example, further comprising the at least partially circumferential protruding portion has an outer dimension of at least 500 µm.

Another example (e.g., example 9) relates to a previous example (e.g., one of the examples 1 to 8) or to any other example, further comprising that a footprint of an area of the surface of the anti-sticking element configured to contact the other one of the flexible element or the second layer is at most 75% of a footprint of a base area of the anti-sticking element.

Another example (e.g., example 10) relates to a previous example (e.g., one of the examples 1 to 9) or to any other example, further comprising that the anti-sticking element comprises or is made of a material different from the flexible element.

Another example (e.g., example 11) relates to a previous example (e.g., one of the examples 1 to 10) or to any other example, further comprising that the anti-sticking element comprises or is made of at least one of a conductive material or an insulating material.

Another example (e.g., example 12) relates to a previous example (e.g., one of the examples 1 to 11) or to any other example, further comprising that the flexible element and the layer form a capacitor.

An example (e.g., example 13) relates to a microelectromechanical system, MEMS, comprising a semiconductor device according to any one of the preceding examples.

Another example (e.g., example 14) relates to a previous example (e.g., example 13) or to any other example, further comprising that the MEMS system is a capacitor microphone.

An example (e.g., example 15) relates to a method, comprising forming a sacrificial layer over a flexible element or a counterpart layer of a microelectromechanical system, forming a recess in the sacrificial layer, a bottom of the recess comprising an average surface roughness of at least 2 nm, filling the recess and covering the sacrificial layer, and removing the sacrificial layer to form the other one of the flexible element or the counterpart layer.

An example (e.g., example 16) relates to a method, comprising forming a sacrificial layer over a flexible element or a counterpart layer of a microelectromechanical system, forming a recess in the sacrificial layer, the recess comprising a protruding portion in a center of the recess, wherein the protruding portion has a height of at least 10 nm, filling the recess and covering the sacrificial layer, and removing the sacrificial layer to form the other one of the flexible element or the counterpart layer.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A semiconductor device (100a; 100b), comprising:
a flexible element (110a; 110b) configured to convert a sound wave into a displacement of the flexible element (1 10a; 1 10b);
a layer (120a; 120b) spaced apart from and facing the flexible element (1 10a; 110b); and an anti-sticking element (130) arranged between the flexible element (110a; 110b) and the layer (120a; 120b) and arranged on the flexible element (1 10a; 110b) or the layer (120a; 120b), the anti-sticking element (130) configured to prevent the flexible element (110a; 110b) and the layer (120a; 120b) from sticking together, and wherein
a surface (240a; 240b) of the anti-sticking element (130) facing the other one of the flexible element (110a; 110b) or the layer (120a; 120b) comprises a recess (242a; 242b) ,
wherein the recess (242a; 242b) has a depth of at least 10 nm.

2. A semiconductor device (100a; 100b), comprising:
a flexible element (110a; 110b) configured to convert a sound wave into a displacement of the flexible element (1 10a; 1 10b);
a layer (120a; 120b) spaced apart from and facing the flexible element (1 10a; 110b); and an anti-sticking element (130) arranged between the flexible element (110a; 110b) and the layer (120a; 120b) and arranged on the flexible element (1 10a; 110b) or the layer (120a; 120b), the anti-sticking element (130) configured to maintain a minimum distance between the flexible element (1 10a; 110b) and the layer (120a; 120b), and wherein
an average surface roughness of a surface (240c) of the anti-sticking element (130) facing the other one of the flexible element (110a; 110b) or the layer (120a; 120b) is at least 2 nm.

3. The semiconductor device (100; 100b) according to any one of the preceding claims, wherein
the anti-sticking element (130) has an at least partially circumferential protruding portion (234a; 234b; 234c).

4. The semiconductor device (100; 100b) according to claim 3, wherein
the at least partially circumferential protruding portion (234a; 234b; 234c) is ring-shaped or rectangular.

5. The semiconductor device (100; 100b) according to claim 3 or 4, wherein
a footprint of the at least partially protruding portion (234a; 234b; 234c) is at most 75% of a footprint of a base area of the anti-sticking element (130).

6. The semiconductor device (100; 100b) according to any one of the claims 1 or 3-5, wherein
the surface (240b) along the recess (242b) of the anti-sticking element (130) is concave.

7. The semiconductor device (100; 100b) according to any one of claims 3-6, wherein
the at least partially circumferential protruding portion (234a; 234b; 234c) has a width of at most 300 nm.

8. The semiconductor device (100; 100b) according to any one of claims 3-7, wherein
the at least partially circumferential protruding portion (234a; 234b; 234c) has an outer dimension of at least 500 µm.

9. The semiconductor device (100; 100b) according to any one of the preceding claims, wherein
a footprint of an area of the surface of the anti-sticking element (130) configured to contact the other one of the flexible element (1 10a; 110b) or the layer (120a; 120b) is at most 75% of a footprint of a base area of the anti-sticking element (130).

10. The semiconductor device (100; 100b) according to any one of the preceding claims, wherein
the anti-sticking element (130) comprises or is made of a material different from the flexible element (110a; 110b).

11. The semiconductor device (100; 100b) according to any one of the preceding claims, wherein
the anti-sticking element (130) comprises or is made of at least one of a conductive material or an insulating material.

12. A microelectromechanical system (1100), MEMS, comprising
a semiconductor device (100; 100b) according to any one of the preceding claims.

13. The MEMS (1100) system according to claim 13, wherein
the MEMS (1100) system is a capacitor microphone.

14. A method (800), comprising:
forming (810) a sacrificial layer over a flexible element or a counterpart layer of a microelectromechanical system;
forming (820) a recess in the sacrificial layer, a bottom of the recess comprising an average surface roughness of at least 2 nm;
filling (830) the recess and covering the sacrificial layer; and
removing (840) the sacrificial layer to form the other one of the flexible element or the counterpart layer.

15. A method (900), comprising:
forming (910) a sacrificial layer over a flexible element or a counterpart layer of a microelectromechanical system;
forming (920) a recess in the sacrificial layer, the recess comprising a protruding portion in a center of the recess, wherein the protruding portion has a height of at least 10 nm, filling (930) the recess and covering the sacrificial layer; and
removing (940) the sacrificial layer to form the other one of the flexible element or the counterpart layer.

## Amended claims

### Amended claims in accordance with Rule 137(2) EPC.

1. A semiconductor device (100a; 100b), comprising:
a flexible element (110a; 110b) configured to convert a sound wave into a displacement of the flexible element (110a; 110b);
a layer (120a; 120b) spaced apart from and facing the flexible element (110a; 110b); and
an anti-sticking element (130) arranged between the flexible element (110a; 110b) and the layer (120a; 120b) and arranged on the flexible element (110a; 110b) or the layer (120a; 120b), the anti-sticking element (130) configured to prevent the flexible element (110a; 110b) and the layer (120a; 120b) from sticking together, wherein the anti-sticking element (130) has an outer dimension of a base of at most 10 µm and wherein
a surface (240a; 240b) of the anti-sticking element (130) facing the other one of the flexible element (110a; 110b) or the layer (120a; 120b) comprises a recess (242a; 242b),
wherein the recess (242a; 242b) has a depth of at least 10 nm.

2. A semiconductor device (100a; 100b), comprising:
a flexible element (110a; 110b) configured to convert a sound wave into a displacement of the flexible element (110a; 110b);
a layer (120a; 120b) spaced apart from and facing the flexible element (110a; 110b); and
an anti-sticking element (130) arranged between the flexible element (110a; 110b) and the layer (120a; 120b) and arranged on the flexible element (110a; 110b) or the layer (120a; 120b), the anti-sticking element (130) configured to maintain a minimum distance between the flexible element (110a; 110b) and the layer (120a; 120b), wherein the anti-sticking element (130) has an outer dimension of a base of at most 10 µm and wherein
an average surface roughness of a surface (240c) of the anti-sticking element (130) facing the other one of the flexible element (110a; 110b) or the layer (120a; 120b) is at least 2 nm.

3. The semiconductor device (100; 100b) according to any one of the preceding claims,
wherein
the anti-sticking element (130) has an at least partially circumferential protruding portion (234a; 234b; 234c).

4. The semiconductor device (100; 100b) according to claim 3, wherein
the at least partially circumferential protruding portion (234a; 234b; 234c) is ring-shaped or rectangular.

5. The semiconductor device (100; 100b) according to claim 3 or 4, wherein
a footprint of the at least partially protruding portion (234a; 234b; 234c) is at most 75% of a footprint of a base area of the anti-sticking element (130).

6. The semiconductor device (100; 100b) according to any one of the claims 1 or 3-5, wherein
the surface (240b) along the recess (242b) of the anti-sticking element (130) is concave.

7. The semiconductor device (100; 100b) according to any one of claims 3-6, wherein
the at least partially circumferential protruding portion (234a; 234b; 234c) has a width of at most 300 nm.

8. The semiconductor device (100; 100b) according to any one of claims 3-7, wherein
the at least partially circumferential protruding portion (234a; 234b; 234c) has an outer dimension of at least 500 µm.

9. The semiconductor device (100; 100b) according to any one of the preceding claims, wherein
a footprint of an area of the surface of the anti-sticking element (130) configured to contact the other one of the flexible element (110a; 110b) or the layer (120a; 120b) is at most 75% of a footprint of a base area of the anti-sticking element (130).

10. The semiconductor device (100; 100b) according to any one of the preceding claims, wherein
the anti-sticking element (130) comprises or is made of a material different from the flexible element (110a; 110b).

11. The semiconductor device (100; 100b) according to any one of the preceding claims, wherein
the anti-sticking element (130) comprises or is made of at least one of a conductive material or an insulating material.

12. A microelectromechanical system (1100), MEMS, comprising
a semiconductor device (100; 100b) according to any one of the preceding claims.

13. The MEMS (1100) system according to claim 13, wherein
the MEMS (1100) system is a capacitor microphone.

14. A method (800), comprising:
forming (810) a sacrificial layer over a flexible element or a counterpart layer of a microelectromechanical system;
forming (820) a recess having an outer dimension of at most 10 µm in the sacrificial layer,
a bottom of the recess comprising an average surface roughness of at least 2 nm; filling (830) the recess and covering the sacrificial layer; and
removing (840) the sacrificial layer to form the other one of the flexible element or the counterpart layer.

15. A method (900), comprising:
forming (910) a sacrificial layer over a flexible element or a counterpart layer of a microelectromechanical system;
forming (920) a recess having an outer dimension of at most 10 µm in the sacrificial layer,
the recess comprising a protruding portion in a center of the recess, wherein the protruding portion has a height of at least 10 nm,
filling (930) the recess and covering the sacrificial layer; and
removing (940) the sacrificial layer to form the other one of the flexible element or the counterpart layer.
